# EUROPÄISCHE PATENTANMELDUNG

(11) **EP 1 318 531 A1**
(43) Veröffentlichungstag der Anmeldung: **11.06.2003**
(21) Anmeldenummer: 02027266.2
(22) Anmeldetag: 06.12.2002
(51) Int. Cl.: H01F 41/04, H01F 17/00, H01L 21/02, H01L 23/64

(54) **Verfahren zur Herstellung von elektronischen Bauteilen sowie elektronisches Bauteil**

(30) Priorität: 06.12.2001 DE 10159826
(71) Anmelder: Ekkehard D. Hans, 88131 Lindau (DE)
(72) Erfinder: Ekkehard D. Hans, 88131 Lindau (DE)
(74) Vertreter: Patentanwälte Eisele, Otten, Roth& Dobler

(57) **Zusammenfassung**

Es wird ein Verfahren zur Herstellung von elektronischen Bauteilen (1) mit übereinander liegenden leitenden flächigen Strukturen (3, 7, 11) vorgeschlagen, deren Überlappungsbereich bis auf eine Verbindungsstelle (3b, 9a) zur elektrischen Verbindung der Strukturen (3, 7, 11) jeweils durch eine elektrisch isolierende Schicht (5, 9) voneinander getrennt ist. Erfindungsgemäß werden die Lagen (3, 5, 7, 9, 11) von elektrisch leitendem Material für die leitenden Strukturen und von isolierendem Material für die Isolationsschicht derart strukturiert übereinander aufgebracht, so dass die leitenden Strukturen (3, 7, 11) an der Verbindungsstelle (3b, 9a) nach dem Aufbringen in elektrischem Kontakt stehen. Bevorzugt werden damit Induktanzen mit räumlich gewundenen Leitern hergestellt.

## Beschreibung

Die Erfindung betrifft ein Verfahren zur Herstellung von elektronischen Bauteilen nach dem Oberbegriff des Anspruchs 1 sowie ein elektronisches Bauteil nach dem Oberbegriff des Anspruchs 8.

### Stand der Technik

Bei in Schichten hergestellten elektronischen Bauteilen stellt sich regelmäßig das Problem, wie auf möglichst rationelle Weise leitende Lagen verschiedener Ebenen, die durch isolierende Lagen voneinander getrennt sind, an vorgegebenen Stellen miteinander verbunden werden können.

Aus dem US-Patent 6,200,405 B1 ist ein Verfahren zur Herstellung eines z.B. "Mehrlagentransformators" bekannt, das folgende Prozessschritte umfasst:

Ein Prozess A zur Vorbereitung einer keramischen Grundschicht, ein Prozess B, um in der keramischen Grundschicht Durchgangslöcher auszubilden, ein Prozess C, um auf der keramischen Grundschicht einen Leiter auszubilden und einem Prozess D, um die keramischen Grundschichten übereinander zu stapeln, wobei der Prozess B mit Hilfe eines Lasers in einer Weise auf der keramischen Grundschicht ausgeführt wird, dass Durchgangslöcher in der empfindlichen keramischen Grundschicht mit Nadelspitzengenauigkeit ausgebildet werden.

Es ist leicht einsehbar, dass ein derartiges Verfahren aufwendig ist, was die Herstellungskosten entsprechender Bauteile nach oben treibt.

### Aufgabe und Vorteile der Erfindung

Der Erfindung liegt die Aufgabe zugrunde, elektronische Bauteile mit übereinander liegenden leitenden, flächigen Strukturen, deren Überlappungsbereich bis auf eine Verbindungsstelle zur elektrischen Verbindung der Strukturen jeweils durch eine elektrisch isolierende Schicht voneinander getrennt ist, kostengünstiger bereitzustellen.

Diese Aufgabe wird durch die Merkmale des Anspruchs 1 und 11 gelöst.

In den Unteransprüchen sind vorteilhafte und zweckmäßige Weiterbildungen der Erfindung angegeben.

Die Erfindung geht zunächst von einem Verfahren zur Herstellung von elektronischen Bauteilen, z.B. von Induktanzen, Transformatoren, Spulen, Antennen oder dergleichen mit übereinander liegenden leitenden, flächigen Strukturen aus, deren Überlappungsbereich bis auf eine Verbindungsstelle zur elektrischen Verbindung der Strukturen jeweils durch eine elektrisch isolierende Schicht voneinander getrennt ist. Der Kern der Erfindung liegt nun darin, dass die Lagen von elektrisch leitendem Material für die leitenden, flächigen Strukturen und von isolierendem Material für die Isolationsschicht zwischen den leitenden Strukturen derart strukturiert übereinander aufgebracht werden, so dass die leitenden Strukturen an der Verbindungsstelle nach dem Aufbringen in elektrischem Kontakt stehen. Durch diese Vorgehensweise lassen sich Schichtungen von leitenden Strukturen und dazwischen liegenden Isolatoren herstellen, bei denen die leitenden Strukturen über die Schichten hinweg in Verbindung stehen, ohne dass es erforderlich wäre, Kontaktlöcher durch die Isolationsschicht in einem gesonderten Prozessschritt zu schaffen. In einer einfachsten Ausführungsform werden die Isolationsschichten so strukturiert aufgebracht, dass an einer Stelle ein Freibereich entsteht, durch welchen eine unter der Isolationsschicht angeordnete elektrisch leitende Schicht mit einer auf der Isolationsschicht aufgebrachten elektrisch leitenden Schicht elektrisch verbunden ist. Vorzugsweise wird jedoch mindestens eine elektrische Lage ebenfalls strukturiert aufgebracht. Es können auch alle Lagen bereits vollständig fertig strukturiert aufgebracht werden. Damit wird eine gegebenenfalls notwendige Nacharbeit zum Aufbau eines Bauteils auf ein Minimum reduziert. Die Erfindung macht sich die prinzipielle Erkenntnis zunutze, dass ein Übereinanderordnen einer Vielzahl von strukturiert aufgebrachten Schichten, insbesondere Isolationsschichten, möglich ist, um komplexere Bauteile rationell zu realisieren. Beispielsweise lässt sich dadurch auf elegante Art ein dreidimensional gewundener Leiter herstellen, um damit z.B. eine Induktanz oder einen Transformator aufzubauen.
Das erfindungsgemäße Verfahren hat bereits Vorteile bei einer Mindestzahl von zwei leitenden Lagen. Die Vorteile kommen jedoch erst richtig zum Tragen, wenn mehr als drei Lagen, was bei elektromagnetischen Bauteilen für den Aufbau eines räumlich gewundenen Leiters nahezu immer der Fall ist, miteinander elektrisch verbunden werden sollen. Bei Induktanzen oder Transformatoren werden regelmäßig mehr als 10 elektrische Lagen leitend miteinander verbunden.

In einer bevorzugten Ausgestaltung der Erfindung wird das jeweilige leitende und isolierende Material in Form einer viskosen Paste aufgebracht. Zum Aufbringen viskoser Pasten eignen sich verschiedene Verfahren. Vorzugsweise wird die jeweilige Lage durch eine Maske hindurch, z.B. in einem Siebdruck- oder Gießverfahren aufgebracht. Für den Auftrag von viskosen Pasten kommen derzeit vor allem Siebdruckverfahren zur Anwendung. Dabei wird die jeweilige Paste durch ein strukturiertes Sieb an den offenen Stellen des Siebes auf eine Oberfläche aufgedruckt. Durch die Verwendung viskoser Pasten lassen sich außerdem Unebenheiten von bereits erzeugten Lagen leicht ausgleichen. Die viskosen Pasten können am Ende eines Aufbringschritts nach mehreren Aufbringschritten oder am Schluss der Deposition getrocknet und/oder gebacken (gesintert) werden. Das strukturierte Aufbringen einzelner oder mehrerer leitender oder isolierender Lagen kann auch in einem Sputter- oder Aufdampfprozess erfolgen. Zur strukturierten Aufbringung erfolgt vorzugsweise die Deposition der Schichten durch eine Maske hindurch. Vorteilhafterweise werden leitende und isolierende Schichten in einem Vakuumschritt durch die jeweilige Maske hindurch strukturiert deponiert.

Im Weiteren ist es besonders vorteilhaft, wenn mit den Lagen von elektrisch leitendem isolierendem Material eine räumlich gewundene Leiterwendel mit freier Struktur im Bereich der Windungsachse vorbereitet wird, wobei die im Bereich der Windungsachse freie Struktur durch Entfernen von Lagen erzeugt wird. Dadurch wird auf besonders einfache Weise ein räumlich gewundener Leiter hergestellt, der z.B. für eine Induktanz oder einen Transformator genutzt werden kann. Durch die vorgeschlagene Herstellungsart kann z.B. die Isolationsschicht weitgehend durchgehend aufgebracht werden, d.h. auch im Bereich der Windungsachse, was die Prozessführung zum Erhalt eines gleichmäßig geschichteten Bauteils erleichtert. Material im Bereich der Windungsachse kann nach dem Aufbringvorgang durch z.B. Stanzen, Bohren oder dergleichen entfernt werden. Prinzipiell ist es auch möglich, die elektrisch leitende Schicht weitgehend durchgehend, insbesondere im Bereich der Bindungsachse aufzubringen. Damit wird eine gleichmäßige Schichtung des Bauteils weiter erleichtert. Die eigentlichen Windungsstrukturen werden dann durch das Entfernen des Materials im Kernbereich der Windung erhalten.

Für eine sichere Prozessführung wird es bevorzugt sein, dass bei der Herstellung der Aussparung im Kernbereich der Wendel die leitenden Lagen gar nicht berührt werden.

Die Aussparung kann unmittelbar nach dem Aufbringen der Schichten, z.B. einem Druckvorgang, also noch vor einem möglichen Sinterprozess erzeugt werden. Es ist jedoch genauso möglich, den Kernbereich nach einem Sinterprozess auszusparen.

Um sich einen nachfolgenden Bearbeitungsschritt zu ersparen, ist es überdies vorteilhaft, wenn die Lagen von elektrisch leitendem Material und isolierendem Material derart strukturiert übereinander aufgebracht werden, dass eine räumlich gewundene Windel mit freier Struktur im Bereich der Windungsachse bereits nach dem Aufbringungsvorgang entsteht.

Um mit einer Leiterwendel Induktanzen oder Transformatoren aufzubauen, wird die Leiterwendel vorzugsweise mit magnetisch leitendem Material ausgestattet. Hierzu kann beispielsweise ein vorgefertigter Ferritkern in die vorbereitete Wendel eingeschoben werden. Der Ferritkern kann dabei zumindest auf einer Seite in einen verbreiterten Bereich übergehen und gegebenenfalls auch zweischalig sein, um einen geschlossenen magnetischen Kreis zu erhalten. Ein derartiges Bauteil wird beispielsweise eine Größe aufweisen, bei welchem der Kern einen Querschnitt von 25 bis 100 mm² besitzt. Es sind jedoch auch wesentlich kleinere oder auch größere Bauteile möglich.

Das magnetisch leitende Material, insbesondere das Kernmaterial im Bereich der Leiterwendel lässt sich aber auch aus planarem Magnetmaterial, d.h. blechartigem Magnetmaterial, z.B. planarem Mumetall, durch Schichtung des Materials aufbauen. Genauso ist es jedoch möglich, eine Kombination von vorgefertigten Ferritbauteilen und planarem Magnetmaterial für die Herstellung einer geeigneten magnetisch leitenden Struktur für eine oder mehrere erfindungsgemäß hergestellte Leiterwendeln einzusetzen.

Beispielsweise wird das planare Magnetmaterial nur zur Ausbildung von Deckschichten zur Schließung eines magnetischen Kreises verwendet. Dabei kann im Kern ein Ferritkern angeordnet sein.

Insbesondere planares "Mumetall" kann in unterschiedlichen Formen und Größen benutzt werden. Die Bearbeitung von derartigem Material ist vergleichsweise einfach, beispielsweise lässt es sich mit einer Schere zuschneiden. Bei größeren Bauteilen oder einer Serienfertigung bietet sich eine Strukturgebung durch Lasertechnik an.

In einer besonders bevorzugten Ausgestaltung der Erfindung werden die leitenden Strukturen als Windungsabschnitte eines dreidimesional gewundenen Leiters mit einem Anfangs- und Endpunkt ausgebildet, wobei der Endpunkt eines Windungsabschnitts einer leitenden Lage mit dem Anfangspunkt eines Windungsabschnitts der darauffolgenden leitenden Lage an einer Verbindungsstelle durch einen freien Bereich in der dazwischen liegenden isolierenden Lage elektrisch verbunden ist, und wobei die Lagen aus elektrisch leitendem und elektrisch isolierendem Material in jeweils dazwischen liegenden Verfahrensschritten in eine Auffülllage eingebettet werden, die ebenfalls fertig strukturiert aufgebracht wird. Durch die Auffülllage kann jeweils eine ebene Oberfläche mit Leiter- oder Isolationsstrukturen erzeugt werden, so dass sich der darauffolgende Depositionsschritt bei planen Bedingungen ausführen lässt.

Als Auffülllage kann außerdem ein magnetisch leitendes Material eingesetzt werden, so dass Induktanzen, Transformatoren, insbesondere Transformatoren mit mehreren Windungen herstellbar sind.

Um einen vollständig geschlossenen magnetischen Kreis zu erhalten, wird im Weiteren vorgeschlagen, dass die in magnetisch leitende Lagen eingebettete Schichtung aus Windungsabschnitten und isolierenden Lagen sandwichartig mit magnetisch leitenden Deckschichten versehen werden. Diese werden z.B. bei einem Siebdruckverfahren am Anfang und am Ende des Herstellungsprozesses auf die Schichtung aufgebracht.

Zur einfachen Schaffung von Kontaktstellen an einem hergestellten Bauteil wird im Weiteren vorgeschlagen, dass beim Schichtaufbau wenigstens ein Abschnitt einer leitenden Lage innerhalb der Schichtung von keiner darauffolgenden Schichtung überdeckt wird. D.h. von der zur Kontaktierung vorgesehenen Stelle an, weist das Bauteil eine Einkerbung oder einen Abschnitt beispielsweise eine abgeschnittene Ecke auf. Ein Transformator kann beispielsweise aus mehreren nach dem erfindungsgemäßen Verfahren hergestellten separaten Leiterwicklungen bestehen. Die Leiterwicklungen können bereits mit magnetischem Material zur Erzeugung eines magnetischen Kreises versehen sein. Es ist jedoch auch möglich, dass magnetisches Material nachträglich in und/oder an den räumlichen Leiterwendeln angeordnet wird. Die Leiterwicklungen, die eine oder mehrere Anschlussmöglichkeiten für das Beschalten der Wicklungen aufweisen, können hierzu Eckbereiche besitzen, bei welchen von einer bestimmten Lage an der jeweilige Bereich von keiner darauffolgenden Lage überdeckt ist. Der jeweilige Eckbereich, der der Kontaktierung dient, ist mit einer elektrisch leitenden Lage abgeschlossen. Um eine einfache Kontaktierung, bei welcher die Kontakte von der Montageseite aus zugänglich sind, bereitzustellen, wenn mehrere Leiterwicklungen übereinander angeordnet sind, ist es bevorzugt, wenn bei einer eckigen Ausführung, in der Draufsicht betrachtet, z.B. quadratischen oder rechteckigen Form, die einzelnen separaten Leiterwicklungen, insbesondere um die Achse eines Kernbereichs zueinander verdreht werden. Bei zwei Leiterwicklungen bietet sich eine Verdrehung von z. B. 45° an, um dann von der Montageseite von oben an die jeweiligen Kontaktstellen an einer Ecke leicht zu gelangen.

Alternativ können statt eines freibleibenden Kontaktes beim Schichtaufbau Kontakte in die Schichtung eingesetzt bzw. eingegossen werden.

### Zeichnungen

Mehrere Ausführungsbeispiele der Erfindung sind in den Zeichnungen dargestellt und unter Angabe weiterer Vorteile und Einzelheiten näher erläutert. Es zeigen
- Figur 1: eine schematische Darstellung einer aus strukturiert aufgebrachten Schichten gebildeten Induktanz, bei welcher zur Verdeutlichung des Herstellungsverfahren die Schichten voneinander beabstandet, dargestellt sind,
- Figur 2a: einen Schnitt durch einen aus Schichten gebildeten Transformator,
- Figur 2b: das Schnittbild gemäß Figur 2a mit zum größten Teil voneinander beabstandeten Schichten zur Verdeutlichung der Schichtfolge,
- Figur 3a und 3b: eine weitere Ausführungsform eines Transformators in zu Figur 2a und b entsprechenden Darstellungen.

### Beschreibung der Ausführungsbeispiele

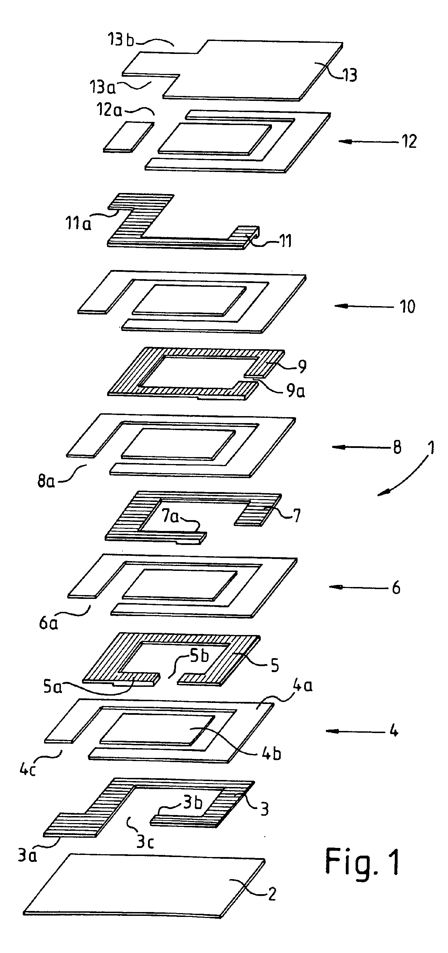

In Figur 1 ist eine Induktanz 1 mit beispielhaft etwas mehr als zwei Windungen mit voneinander beabstandeten Schichten zur Veranschaulichung der Schichtfolge dargestellt. Die Induktanz 1 wird z.B. in einem Siebdruckverfahren Schicht für Schicht aufgebaut.

Zunächst wird eine Deckschicht 2 aus magnetisch leitendem Material gedruckt. Darauf folgt eine zu dreiviertel ausgebildete Windung eines Leiters 3, die unmittelbar auf die Deckschicht 2 über ein entsprechend strukturiertes Sieb gedruckt wird.

Um für einen nachfolgenden "Printschritt" ebene Bedingungen bereitzustellen, wird in den freien Raum zwischen dem Leiter 3 in der Leiterebene eine Füllschicht 4 strukturiert gedruckt. Diese Füllschicht 4 hat zugleich die Aufgabe, einen magnetischen Kreis auszubilden, weshalb der äußere Ring 4a mit dem Kernbereich 4b nicht verbunden sein darf. Im äußeren Ring 4b ist jedoch ein Bereich 4c zum Kontaktieren einer Kontaktstelle 3a am Leiter 3 ausgespart. Damit wird bis auf einen Bereich 3c, in dem der Leiter 3 seine Windung nicht vervollständigt, eine vollkommen ebene Lage gebildet.

Diese Vertiefung 3c wird im darauffolgenden Prozessschritt ausgeglichen, bei welchem über den Leiter 3 eine entsprechend ausgeformte Isolationsschicht 5 strukturiert aufgedruckt wird. Bei diesem Printschritt kann durch überschüssiges Material an der Stelle 5a die Lücke 3c in der darunter liegenden Ebene ausgefüllt werden.

Nun folgt wiederum eine Füllschicht 6 aus magnetisch leitendem Material, mit der der magnetische Kreis aufgebaut wird, und welche für eine Einebnung der bisherigen Schichtfolge für den darauffolgenden Printschritt sorgt. Bei der Füllschicht 6 ist nach wie vor eine Ecke 6a ausgespart, um die Kontaktstelle 3a freizulassen.

Die Isolationsschicht 5 deckt den Leiter 3 nicht vollständig ab, sondern lässt einen Bereich 5b, der mit einem Bereich 3b auf dem darunter liegenden Leiter 3 korrespondiert, frei. D.h. bis auf die Stelle 5b ist wiederum das bislang aufgebaute Bauteil vollkommen eingeebnet.

In einem nächsten Printschritt wird ein Leiter 7 strukturiert deponiert, der die Stelle 5b durch überschüssiges Printmaterial im Bereich 7a auffüllt und dabei eine elektrische Verbindung mit dem darunter liegenden Leiter 3 an dieser Stelle ausbildet. Es folgt wiederum eine Füllschicht 8 mit ausgespartem Bereich 8a für die Kontaktstelle 3a gefolgt von einer weiteren Isolationsschicht 9, die jedoch an einer im Vergleich zur Isolationsschicht 5 versetzten Stelle 9a den darunter liegenden Leiter 7 für einen weiteren darüber liegenden Leiter 11 freilässt.

Zwischen dem Leiter 11 und der Isolationsschicht 9 folgt wiederum die Aufbringung einer Füllschicht 10. Nach dem Leiter 11 wird nochmals eine Füllschicht 12 gedruckt, die nunmehr an der Stelle 12a zusätzlich ausgespart ist, um eine Kontaktstelle 11a am Leiter 11 zur Ausbildung des zweiten Anschlusses der sich nun gebildeten Spule freizulassen. Zur Vervollständigung des magnetischen Kreises wird die Schichtung mit einer Deckschicht 13 aus magnetischem Material abgedeckt, die Aussparungen 13a und 13b für die Kontaktstellen 3a und 11a aufweist.

Ein reales Bauteil wird nach diesem Prinzip aufgebaut werden. Dabei müssen normalerweise eine größere Anzahl von Windungen von Leitern 3, 7, 11 realisiert werden. Dies ist jedoch auf einfache Weise durch Einfügung entsprechender weiterer Schichten leicht möglich. Dabei erfordert nicht jede zusätzliche Windung einen eigenen Maskensatz für den Leiter und die Isolationsschicht. Vielmehr können die einzelnen Printmasken nach einer vorgegebenen Windungszahl wieder für die nächstfolgende Windungszahl zum Einsatz kommen.

Das auf diese Weise hergestellte Bauteil muss gegebenenfalls noch einem Temperschritt unterzogen werden und ist dann fertiggestellt. D.h. bei diesem Verfahren entfällt die normalerweise notwendige Herstellung von Durchkontaktierungen zur elektrischen Verbindung der einzelnen Leiterschichten in einem separaten Schritt.

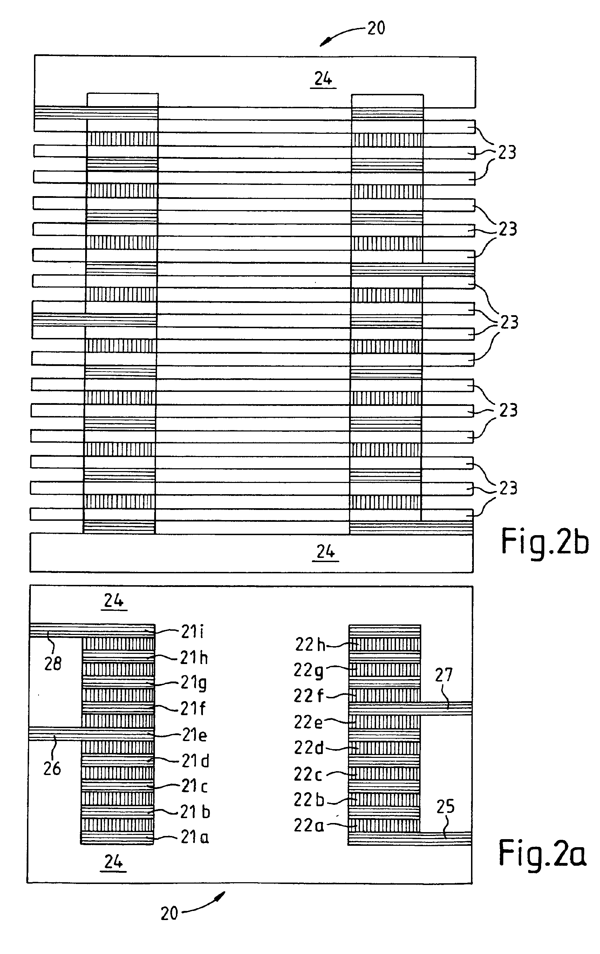

Figur 2a zeigt einen Schnitt auf einen fertiggestellten Transformator mit insgesamt neun Leiterebenen 21a bis 21i, die durch Isolationsschichten 22a bis 22h mit Ausnahme einer Verbindungsstelle (nicht dargestellt) voneinander getrennt sind. Die leitenden Schichten 21a bis 21i sowie die Isolationsschichten 22a bis 22h sind in magnetisch leitende Füllschichten 23 eingebettet (siehe hierzu auseinandergezogene Darstellung des Transformators 20 gemäß Figur 2b). Zusätzlich sind jeweils drei Deckschichten 24 auf der Ober- und Unterseite des Transformators 20 vorgesehen, um einen vollständig magnetischen Kreis zu realisieren.

Beim Transformator 20 bilden die Leiterebenen 21a bis 21e einen Windungsblock und die Leiterebenen 21f bis 21i einen zweiten Windungsblock, so dass eine Primärwicklung und eine Sekundärwicklung mit einem Windungsverhältnis von 3:2 realisiert ist.

Der erste Windungsblock wird an den Stellen 25 und 26 kontaktiert, der zweite Windungsblock an den Stellen 27 und 28.

An diesen Stellen ist das Bauteil jeweils nach oben in entsprechender Weise, wie in Figur 1 veranschaulicht, ausgespart. Dies ist an den Schnittdarstellungen von Figur 2a und 2b nicht ersichtlich.

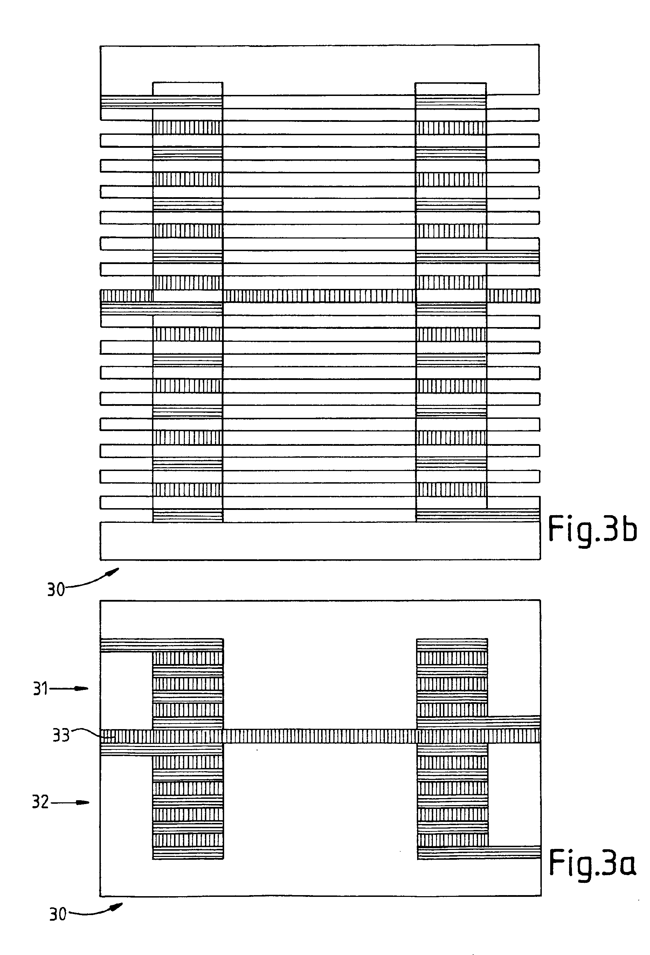

Figur 3a und 3b zeigt in entsprechender Weise wie Figur 2a und 2b eine weitere Ausführungsform eines Transformators 30. Dieser unterscheidet sich vom Transformator 20 dadurch, dass zwischen Windungsblöcken 21 und 22 eine nicht magnetisch leitende Schicht zur Realisierung vorgegebener elektrischer Eigenschaften des Bauteils angeordnet ist.

### Bezugszeichenliste:

- 1: Induktanz
- 2: Deckschicht
- 3: Leiter
- 3a: Kontaktstelle
- 3b: Bereich
- 3c: Bereich
- 4: Füllschicht
- 4a: äußerer Ring
- 4b: Kernbereich
- 4c: Bereich
- 5: Isolationsschicht
- 6: Füllschicht
- 7: Leiter
- 7a: Bereich
- 8: Füllschicht
- 8a: ausgesparter Bereich
- 9: Isolationsschicht
- 9a: Stelle
- 10: Füllschicht
- 11: Leiter
- 11a: Kontaktstelle
- 12: Füllschicht
- 12a: Stelle
- 13: Deckschicht
- 13a: Aussparung
- 13b: Aussparung
- 20: Transformator
- 21 a - i: Isolationsschicht
- 22 a - h: Füllschicht
- 24: Deckschicht
- 25 - 28: Kontaktstelle
- 30: Transformator
- 31: Wicklungsblock
- 32: Wicklungsblock
- 33: nicht magnetisch leitende Schicht

## Patentansprüche

1. Verfahren zur Herstellung von elektronischen Bauteilen (1, 20, 30) mit übereinander liegenden leitenden, flächigen Strukturen (3, 7, 10), deren Überlappungsbereich bis auf eine Verbindungsstelle (3b) zur elektrischen Verbindung der Strukturen (3, 7, 11) jeweils durch eine elektrisch isolierende Schicht (5, 9) getrennt ist, **dadurch gekennzeichnet, dass** die Lagen (3, 5, 7, 9, 11) von elektrisch leitendem Material für die leitenden Strukturen und von isolierendem Material für die Isolationsschicht derart strukturiert übereinander aufgebracht werden, so dass die leitenden Strukturen (3, 7, 11) an der Verbindungsstelle (3b, 9a) nach dem Aufbringen in elektrischem Kontakt stehen.

2. Verfahren nach Anspruch 1, **dadurch gekennzeichnet, dass** das jeweilige leitende und isolierende Material in Form einer viskosen Paste aufgebracht wird.

3. Verfahren nach Anspruch 1 oder 2, **dadurch gekennzeichnet, dass** die jeweiligen leitenden und isolierenden Lagen (3, 5, 7, 11) durch eine Maske hindurch aufgebracht werden.

4. Verfahren nach einem der vorhergehenden Ansprüche, **dadurch gekennzeichnet, dass** mit den Lagen von elektrisch leitendem Material und elektrisch isolierendem Material eine räumlich gewundene Leiterwendel mit freier Struktur im Bereich der Windungsachse vorbereitet wird, wobei die im Bereich der Windungsachse freie Struktur durch Entfernen von Lagen erzeugt wird.

5. Verfahren nach Anspruch 4, **dadurch gekennzeichnet, dass** die Lagen von elektrisch leitendem Material und isolierendem Material derart strukturiert übereinander aufgebracht werden, dass eine räumlich gewundene Leiterwendel mit freier Struktur im Bereich der Windungsachse entsteht.

6. Verfahren nach Anspruch 4 oder 5, **dadurch gekennzeichnet, dass** in die Struktur der Leiterwendel ein Kern aus magnetisch leitendem Material eingesetzt wird.

7. Verfahren nach einem der vorhergehenden Ansprüche, **dadurch gekennzeichnet, dass** die leitenden Strukturen (3, 7, 11) als Windungsabschnitte eines dreidimensional gewunden verlaufenden Leiters mit einem Anfangs- und Endpunkt ausgebildet sind, wobei der Endpunkt eines Windungsabschnitts einer leitenden Lage (3) mit dem Anfangspunkt eines Windungsabschnitts der darauffolgenden leitenden Lage (7) an einer Verbindungsstelle (3b) durch einen freien Bereich (5b) in der dazwischen liegenden isolierenden Lage elektrisch verbunden ist, und wobei die Lagen (3, 5, 7, 9, 11) aus elektrisch leitendem und elektrisch isolierendem Material in jeweils dazwischen liegenden Verfahrensschritten in eine Auffülllage (4, 6, 8, 10, 12) eingebettet werden, die ebenfalls [fertig] strukturiert aufgebracht wird.

8. Verfahren nach einem der vorhergehenden Ansprüche, **dadurch gekennzeichnet, dass** für die Auffülllage (4, 6, 8, 10, 12) ein magnetisch leitendes Material verwendet wird.

9. Verfahren nach einem der vorhergehenden Ansprüche, **dadurch gekennzeichnet, dass** die in magnetisch leitende Lagen (4, 6, 8, 10, 12) eingebettete Schichtung aus Windungsabschnitten und isolierenden Lagen (3, 5, 7, 9, 11) sandwichartig mit magnetisch leitenden Deckschichten (2, 13) versehen werden.

10. Verfahren nach einem der vorhergehenden Ansprüche, **dadurch gekennzeichnet, dass** beim Schichtaufbau wenigstens ein Abschnitt (3a, 11a) einer leitenden Lage innerhalb der Schichtung von keiner darauffolgenden Schicht überdeckt wird.

11. Elektronisches Bauteil mit einer Anordnung aus übereinander liegenden flächigen Lagen (3, 7, 11) aus elektrisch leitendem Material, deren Überlappungsbereich bis auf eine Verbindungsstelle (3b, 9a) zur elektrischen Verbindung der flächigen Lagen (3, 7, 11) jeweils durch eine elektrisch isolierende flächige Schicht (5, 9) getrennt ist, **dadurch gekennzeichnet, dass** beim Schichtaufbau wenigstens ein Abschnitt (3a, 11a) einer leitenden Lagen (3, 11) innerhalb der Schichtung von keiner darauffolgenden Schicht überdeckt ist.
